# EUROPEAN PATENT SPECIFICATION

(11) **EP 2 399 300 B1**
(45) Date of publication and mention of the grant of the patent: **16.10.2019**
(21) Application number: 10705909.9
(22) Date of filing: 17.02.2010
(51) Int. Cl.: H01L 31/0687, H01L 31/18, H01L 31/028

(54) **METHOD FOR FORMING A PHOTOVOLTAIC CELL**
VERFAHREN ZUR BILDUNG EINER PHOTOVOLTAISCHEN ZELLE
PROCEDE DE FORMATION D'UNE CELLULE PHOTOVOLTAIQUE

(30) Priority: 19.02.2009 GB 0902846
(43) Date of publication of application: 28.12.2011
(73) Proprietor: IQE Silicon Compounds Limited, Wales CF3 0LW (GB)
(72) Inventor: HARPER, Robert, Cameron, Newport NP10 9AX (GB)
(74) Representative: Boult Wade Tennant LLP
(86) International application number: PCT/GB2010/000286
(87) International publication number: WO 2010/094919

(56) References cited:
- EP-A2- 1 109 230
- WO-A1-2009/005824
- JP-A- H10 135 494
- US-A1- 2002 072 130
- US-A1- 2004 166 681
- US-A1- 2006 144 435
- NAKAJIMA K ET AL: "Growth of Ge-rich SixGe1-x single crystal with uniform composition (x=0.02) on a compositionally graded crystal for use as GaAs solar cells" JOURNAL OF CRYSTAL GROWTH, ELSEVIER, AMSTERDAM, NL LNKD- DOI:10.1016/S0022-0248(99)00270-5, vol. 205, no. 3, 1 September 1999 (1999-09-01), pages 270-276, XP004181589 ISSN: 0022-0248

## Description

### Field of the invention

The present invention relates to photovoltaic cells, and in particular, but not exclusively, to multi-junction solar cells in which a lower photovoltaic junction for absorbing longer wavelength parts of the solar spectrum is germanium based.

### Introduction

Photovoltaic cells convert light energy, for example sunlight, into useful electrical power. Typically, electron-hole pairs are formed by absorption of photons in a semiconductor material close to a p-n junction which acts to separate the charge carriers which are then delivered to an electric circuit through metallic contacts on the cell device. The absorption process only occurs if a photon has an energy higher than a bandgap of the local semiconductor material, so that a lower bandgap material tends to absorb more photons. Excess energy of a particular photon over the bandgap energy is lost as heat into the semiconductor lattice. If the p-n junction is formed of materials with a higher bandgap, lower energy photons are not absorbed, but the voltage at which the photocurrent is delivered increases.

Sunlight contains significant energy over a wide range of wavelengths, and to maximise efficiency of solar cells it is therefore appropriate to absorb high energy photons in an upper junction with a higher bandgap, and absorb successively lower energy photons in underlying junctions with successively lower characteristic bandgap energies. This technique seeks to maximise the electrical power obtained from each part of the solar spectrum by absorbing higher energy photons in higher voltage junctions. It is known to form the multiple junctions monolithically on a single semiconductor substrate, using epitaxial growth techniques. The photocurrent from each junction flows through the whole structure and is coupled to an external circuit using metallic contacts on top of the upper cell and below the substrate. A solar cell formed in this way is frequently called a multijunction cell.

A well-known multi-junction cell structure is outlined in the introduction of US 6,380,601. The upper, higher bandgap energy junction is based on InGaP materials. The middle junction is based on GaAs materials. The bottom, lower bandgap energy junction is based on Germanium materials. In particular, the lower junction is formed by suitable doping of a Ge substrate on which the middle and upper junctions are formed using epitaxial growth techniques. The materials used in each junction are constrained by the requirements of good quality epitaxial growth that the crystal lattice spacing of each layer matches the spacing of the layer below. Mismatches in lattice spacing of more than a small fraction of 1% lead to growth defects which result in poor material quality and a much lower efficiency solar cell as photo-generated charge carriers recombine more readily within the device. GaAs and Ge are closely lattice matched. The InGaP material can be lattice matched to GaAs by ensuring the correct ratio of the In, Ga and P components. Other materials which may be used in such a triple junction tandem cell must be similarly lattice matched to the substrate and each other.

In US 6,380,601 the Germanium substrate is p-doped with gallium to a concentration of about 1x10¹⁸ cm⁻³. The bottom p-n junction is then formed by diffusion of phosphorous into a surface layer of the Ge substrate. To overcome the bulk p-type doping the diffused n-type phosphorous doping is at a relatively high concentration of about 5x10¹⁸ to 1x10¹⁹ cm⁻³, with the diffusive process leading to a gradual falling off in concentration with depth, rather than a sharp boundary.

An objective in both US 6,380,601, and US 2002/0040727 which describes a similar device, is to improve the properties of the diffused n-type doped layer in the surface of the Ge substrate. However, using the described techniques the thickness of the n-doped layer remains difficult to control accurately, the boundary between the n- and p-doped regions is diffuse in nature, and the concentration of n-type doping must be high to counterbalance the bulk p-type doping of the substrate.

The invention addresses these and other problems of the related prior art. Further related prior art is now discussed.

EP1109230 (A2) discloses a monolithic, multijunction photovoltaic cell comprising: an active substrate subcell comprising one of Si, SiGe and pure Ge, said substrate subcell having a side and being characterized by a substrate subcell bandgap and a substrate subcell lattice constant; at least one subcell disposed adjacent said side, said subcell being characterized by a subcell lattice constant that is different than said substrate subcell lattice constant; and a transition layer intermediate said side and said subcell.

Nakajima K et al, "Growth of Ge-rich SixGe1-x single crystal with uniform composition (x=0.02) on a compositionally graded crystal for use as GaAs solar cells", Journal Of Crystal Growth, Elsevier, vol. 205, no. 3, pages 270 - 276, discloses a growth technology on Ge-rich SiGe crystals on Ge seeds.

US2006144435 (A1) discloses a monolithic, multi-bandgap, tandem solar photovoltaic converter that has at least one, and preferably at least two, subcells grown lattice-matched on a substrate with a bandgap in medium to high energy portions of the solar spectrum and at least one subcell grown lattice-mismatched to the substrate with a bandgap in the low energy portion of the solar spectrum, for example, about 1 eV.

WO2009005824 (A1) discloses the use of an epitaxial lift-off technique in which a sacrificial layer is included in the epitaxial growth between the substrate and a thin film HI-V compound solar cell. To provide support for the thin film III-V compound solar cell in absence of the substrate, a backing layer is applied to a surface of the thin film III-V compound solar cell before it is separated from the substrate. To separate the thin film III-V compound solar cell from the substrate, the sacrificial layer is removed as part of the epitaxial lift-off. Once the substrate is separated from the thin film III-V compound solar cell, the substrate may then be reused in the formation of another thin film III-V compound solar cell.

US2002072130 (A1) discloses a process for producing monocrystalline semiconductor layers. In an exemplary embodiment, a graded Si1-xGex (x increases from 0 to y) is deposited on a first silicon substrate, followed by deposition of a relaxed Si1-yGey layer, a thin strained Si1-zGez layer and another relaxed Si1-yGey layer. Hydrogen ions are then introduced into the strained SizGz layer. The relaxed Si1-yGey layer is bonded to a second oxidized substrate. An annealing treatment splits the bonded pair at the strained Si layer, such that the second relaxed Si1-yGey layer remains on the second substrate. In another exemplary embodiment, a graded Si1-xGex is deposited on a first silicon substrate, where the Ge concentration x is increased from 0 to 1. Then a relaxed GaAs layer is deposited on the relaxed Ge buffer. As the lattice constant of GaAs is close to that of Ge, GaAs has high quality with limited dislocation defects. Hydrogen ions are introduced into the relaxed GaAs layer at the selected depth. The relaxed GaAs layer is bonded to a second oxidized substrate. An annealing treatment splits the bonded pair at the hydrogen ion rich layer, such that the upper portion of relaxed GaAs layer remains on the second substrate.

US2004166681 (A1) disclose a method of forming a multijunction solar cell having lattice mismatched layers and lattice-matched layers comprises growing a top subcell having a first band gap over a growth semiconductor substrate. A middle subcell having a second band gap is grown over the top subcell, and a lower subcell having a third band gap is grown over the middle subcell. The lower subcell is substantially lattice-mismatched with respect to the growth semiconductor substrate. The first band gap of the top subcell is larger than the second band gap of the middle subcell. The second band gap of the middle subcell is larger than the third band gap of the lower subcell. A support substrate is formed over the lower subcell, and the growth semiconductor substrate is removed.

JPH10135494 (A) discloses a method to heighten the efficiency of a solar cell by providing at least one layer of a chemical compound semiconductor layer in a lattice alignment with a specific single crystal substrate and having a pn junction on a specific single crystal substrate.

### Summary of the invention

Accordingly the invention provides a method of forming a photovoltaic cell, such as a solar cell as set out in claim 1.

The photovoltaic cell comprises a germanium based first photovoltaic junction, the junction comprising one or more epitaxially grown first layers of SiGe or another germanium material, lattice matched, or substantially lattice matched to GaAs. In particular, the one or more layers may be grown monolithically with a GaAs substrate, or another substrate providing a GaAs surface such as a GaAs-on-Insulator substrate. The junction may comprise, or be formed by, two such layers of SiGe or another germanium material, which may be oppositely doped, one or both of the layers being distinct epitaxially grown layers of said SiGe and/or Ge materials. Both layers may be lattice matched, or substantially lattice matched to GaAs. Alternatively or additionally the photovoltaic junction may be formed by adding dopants to one or more of the one or more epitaxially grown layers, or other parts such as an underlying layer or substrate, for example by diffusion or beam implant.

Although germanium alone, or SiₓGe₁₋ₓ with a silicon content of up to at least x = 0.04, and perhaps x = 0.06 or more, may be used in the one or more layers of germanium material, the layers are more preferably formed of suitably doped SiₓGe₁₋ₓ in which 0.01≤x≤0.03. Preferably, the first junction has a characteristic bandgap of less than 0.76 eV, and more preferably less than 0.73eV. More generally, however, the term germanium material when used in this document may be a material in which the germanium mole fraction is at least 0.7, optionally at least 0.9, and the germanium material is monocrystalline and/or monolithically formed.

The one or more layers may be grown in one or more stages using an appropriate epitaxial technique such as CVD or MBE. The layers may be doped p- or n- type, to facilitate formation of the photovoltaic junction by dopant diffusion and/or growth of oppositely doped layers.

The one or more first layers may be formed of the same material composition, or the compositions may differ slightly subject to the lattice matching constraints to retain good material quality. The one or more first layers will typically be oppositely doped, but the order of the doping may be selected in line with other design constraints familiar to the skilled person. The first junction and other photovoltaic junctions which may be provided in the cell may comprise other layers or structures such as an intrinsic region between oppositely doped layers.

Compared with the techniques outlined in US 6,380,601, and US 2002/0040727, aspects of the present invention allow the doping concentration of the upper layer of the junction to be significantly reduced, which results in improved carrier recombination lifetimes, and a consequent improvement in open circuit voltage of the junction and overall efficiency. The epitaxial growth of the one or more first layers permits much more accurate control of layer thickness and junction position, and in particular facilitates formation of a thin upper layer, with a sharp junction boundary, which cannot be achieved using diffusive counter-doping methods. Because the one or more first layers are lattice matched to the GaAs, any overlying GaAs layers such as GaAs layers in an overlying photovoltaic junction can be accurately lattice matched leading to reduced growth defects, with consequent improvements in material quality and device performance over a device in which any GaAs junction layers are only approximately lattice matched to an underlying Ge substrate.

For multi-junction solar cell applications it is generally thought desirable to provide a lower junction with a bandgap larger than that provided by germanium, and this is achieved by forming the one or more first layers from SiGe, with the Si content increasing the bandgap of the material. For a silicon content of 2% the bandgap of the junction is approximately 0.68eV.

The processing of Ge wafers to form a diffused lower junction for solar cells tends to be restricted to maximum 100 mm wafer sizes, and the use of a GaAs wafer substrate widens access to larger wafer sizes such as 150mm and 200mm which are more widely available in GaAs.

Typically, the one or more first layers will have been grown epitaxially on or over a GaAs substrate, so as to provide optimal GaAs lattice matching, but in an operable device the GaAs substrate may have been removed as discussed below, for example taking advantage of the etch-stop effect of the Ge or SiGe layer when etching GaAs. To this end, the one or more first layers may be grown directly on and contacting a GaAs surface provided by the substrate. Having removed some or all of the GaAs substrate, this may be replaced by an alternative base, for example a metallic or other heatsink layer or structure, or a cheaper or more convenient substrate such as silicon, which may also have a silicon oxide layer. If a heatsink structure is used, this may be metallic or of another class of material, but should have thermal transfer characteristics better than the GaAs substrate it replaces, for example having a thermal conductivity at least double that of a GaAs substrate at usual operating conditions. Most or all of the GaAs substrate is separated by an exfoliation or layer transfer method then it may be reused in a subsequent process, for example to form other similar or different semiconductor devices.

One or more further photovoltaic junctions are disposed over the first junction having bandgaps larger than that of the first junction. The further junctions may be epitaxially grown and monolithic with the first junction. They are be grown with a different lattice constant using an intervening grade layer, and/or may include junctions separately grown for example on a different substrate and subsequently bonded to form part of the device.

A silicon-germanium grade is formed over the germanium based first photovoltaic junction and said one or more further photovoltaic junctions may then comprise at least a second photovoltaic junction formed over the silicon-germanium grade, the second junction comprising SiGe materials having a higher silicon content than the one or more first layers of the first junction, the silicon-germanium grade being formed to match the lattice constants of the first and second junctions at respective lower and upper boundaries. For typical multi-junction solar cell applications, such a second junction will have a bandgap of around 0.85 to 1.05 eV, although the full range from the bandgap of germanium to the bandgap of silicon is available.

To provide further photovoltaic junctions above the second junction of SiGe materials, noting that the further junctions may not be lattice matched to the second junction (for example they may comprise GaAs layers and be monolithic and lattice matched with such), an ancillary structure may be formed on a separate substrate, the ancillary structure having one or more ancillary photovoltaic junctions having bandgaps larger than the bandgaps of the germanium based first and second photovoltaic junctions. The junctions of the ancillary structure are then bonded on top of the second photovoltaic junction. Conveniently, the junctions of the ancillary structure may be created in inverse formation so that the ancillary structure can be inverted onto the main structure.

One example of a completed photovoltaic cell embodying the invention includes a monolithic triple junction solar cell comprising a first germanium based photovoltaic junction comprising epitaxially grown Ge or SiGe layers substantially lattice matched to GaAs, an epitaxially grown intermediate GaAs based photovoltaic junction, and an upper photovoltaic junction. Another example is quadruple junction solar cell comprising a first, Germanium based photovoltaic junction comprising epitaxially grown Ge or SiGe layers lattice matched to GaAs, a second photovoltaic junction comprising epitaxially grown SiGe layers having a higher silicon content than the Ge or SiGe layers of the first junction, and an intermediate SiGe grade arranged to match the lattice constant of the first and second junctions at its respective faces. Of course, different numbers of junctions and different junction materials can be used.

The invention also provides methods of forming photovoltaic cells as discussed above, for example comprising providing a GaAs substrate, or other substrate providing a GaAs surface, and forming a Germanium based first photovoltaic junction over the GaAs substrate by epitaxial growth of one or more first semiconductor layers of SiGe, Ge, or another germanium material substantially lattice matched to the GaAs substrate. Methods putting into effect the various structures discussed above are also provided.

The first of the one or more first semiconductor layers may be grown directly on the GaAs substrate, thereby providing an etch stop for a subsequent etching step which removes some or all of the GaAs substrate. Other techniques for removing some or all of the GaAs substrate may be used including grinding and layer transfer/exfoliation. Exfoliation techniques may permit re-use of the substrate in the form of a GaAs wafer of slightly reduced thickness. If the GaAs substrate is removed in whole or part, replacement structures or layers such as an alternative semiconductor substrate (for example silicon) or a metallic heatsink may be provided in its place.

### Brief description of the drawings

Embodiments of the invention will now be described, by way of example only, with reference to the accompanying drawings, of which:
Figure 1A illustrates schematically a photojunction formed using SiGe material layers epitaxially grown over a GaAs substrate;
Figure 1B illustrates a similar photojunction, but formed using a single SiGe material layer and dopant diffusion into the substrate;
Figure 1C illustrates a similar photojunction, but formed using a single SiGe material layer and dopant diffusion into the SiGe layer;
Figure 2 shows the structure of figure 1A with additional photojunctions and other functional structures added to form a multijunction monolithic photovoltaic cell, not being part of the invention;
Figures 3A to 3D illustrate a process in which the structure of Figure 2 is bonded to a handling wafer, and the GaAs substrate is removed and replaced with another base structure such as a metallic heatsink;
Figures 4A to 4D illustrate a process in which a structure similar to that of Figure 1A is formed on an alternative substrate such as an oxidised silicon wafer, permitting reuse of the GaAs substrate wafer;
Figure 5 shows according to the invention a structure similar to that of Figure 1A or Figure 4D to which has been added a grade layer and a further photojunction formed of SiGe material layers grown epitaxially on the grade layer with a higher proportion of silicon than in the underlying photojunction;
Figure 6A shows an ancillary photojunction structure. In figure 6B this structure is inverted and bonded to a structure similar that of figure 5. Further processing including removal of the oxidised silicon or other substrates results in the photovoltaic cell shown in figure 6C.

The diagrams, which generally show semiconductor layers in section through a structure, are not drawn to scale. Where p- or n- type doping are indicated, the skilled person will be aware that these can be exchanged to describe a complementary device without loss of function. In the description the terms "above", "below", "over", "under" and similar terms are generally used in the sense that the discussed photovoltaic structures are intended to receive illumination for the purposes of generating a photocurrent from above, although the actual orientation of the structures, cells and devices may clearly be varied to suit particular applications.

For the sake of brevity and generality, not all layers and structures desirable or necessary to form the described photovoltaic cells are illustrated or described, and other functional and non-functional layers may be included within the described structures where the contrary is not indicated in the text.

### Description of embodiments

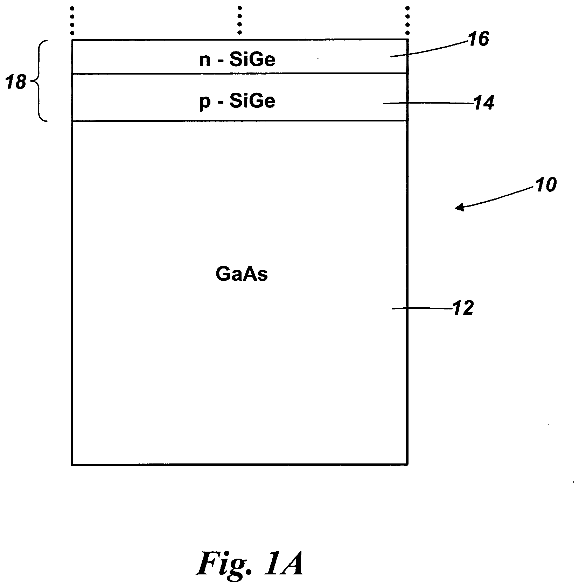

Referring to figure 1A there is shown schematically a photovoltaic cell structure 10 according to a first embodiment of the invention. The structure 10 comprises a GaAs substrate 12. On the GaAs substrate are two successive first layers 14, 16 of a SiGe material grown epitaxially on and monolithically with the GaAs substrate, and these layers together form a first germanium based photovoltaic junction 18. The first layers of SiGe have a silicon content selected so as to be substantially lattice matched to the GaAs substrate. To achieve this the silicon fraction x for SiₓGe₁₋ₓ could lie in the range of 0-0.04, more preferably 0.01-0.03 and more preferably still about 0.016-0.02. To form a practical photovoltaic junction the lower SiGe layer may typically be p-doped to a concentration of about 5x10¹⁶ to 5x10¹⁹ cm⁻³ and have a thickness of about 1-2 µm. The upper SiGe layer may typically be n-doped to a concentration of about 1x10¹⁷ cm⁻³ and have a thickness of about 0.2-1 µm.

Of course, the p- and n- type dopings may be reversed as long as corresponding changes are made in other parts of the structure, as will be apparent to the skilled person. Based on a silicon fraction x for SiₓGe₁₋ₓ of zero, and 0.04, the bandgap of the junction will be about 0.67eV and 0.69eV respectively. The corresponding lattice mismatch of the SiₓGe₁₋ₓ with GaAs will be about 0.04% for every change of 0.01 in x away from the lattice matched condition at about x = 0.018. The junction may be formed using layers in which the Si content is zero or close to zero, in which case the layers may be described as germanium layers rather than SiGe layers, although using SiGe with a closer lattice match to GaAs is advantageous. The compositions of the first layers may be identical or close to identical, or may differ subject to constraints of being substantially lattice matched so as to suppress defect formation.

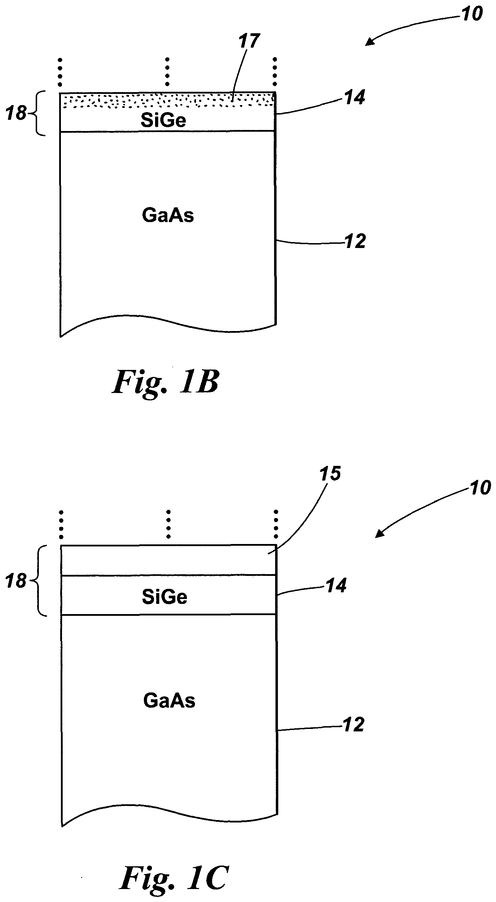

The first germanium based junction and other photovoltaic junctions in the described structures may be provided by doped p- and n- layers in direct contact, or other more complex structures, for example including an intrinsic region of lightly doped or undoped material may be provided between the doped regions as will be familiar to the skilled person. Diffused or otherwise added dopants may also be used, as illustrated in figure 1B discussed below.

Further layers may be formed on top of the first SiGe layers as required, such as further photovoltaic junctions, tunnel junctions between such photovoltaic junctions, window layers, and conductive electrode contacts. Other layers may also be provided between the first SiGe layers and the GaAs substrate, or between the first SiGe layers such as an intrinsic region of undoped SiGe within the photovoltaic junction.

The first SiGe layers 14,16 can be grown on the GaAs substrate 12 using an epitaxy process, as lattice matched layers, using a gas mixture of a germanium containing precursor (e.g. GeH₄, GeCl₄, etc) and a silicon containing precursor (e.g. SiH₄, SiH₂Cl₂, SiHCl₃, disilane, etc) with a carrier gas (e.g. H₂). The first SiGe layers 14,16 can be in-situ doped with p-type or n-type dopants, or both, using gaseous or solid doping sources including, but not limited to, diborane, phosphine and arsine. The layers 14,16 can be grown, for example, at atmospheric pressure or reduced pressure in the range 1-1000 Torr, and temperature 350°C-800°C. A range of GaAs substrates may be used including p-type, n-type and semi-insulating, and the wafers may be cleaned ex-situ or in the process chamber prior to epitaxy. Crystallinity properties of the SiGe layers 14,16 may be measured using X-ray diffraction techniques, for example to check lattice matching, and the thicknesses of the layers may typically be monitored using variable angle spectroscopic ellipsometry, although other techniques are available.

Advantages of this embodiment and the related aspects of the invention are set out in the Summary of the Invention above.

Figure 1B illustrates a variation of figure 1A, in which a single layer of SiGe or another germanium material is used in the formation of a photovoltaic junction. In figure 1B the SiGe layer 14 carries a doping of one type throughout its structure, but is counterdoped by diffusion in an upper region 17, to form a junction within the layer 14. The junction could also be formed by other doping techniques and structures, for example of other regions of the layer, and/or of the substrate. As for figure 1A, further layers may optionally be added. The layer 14 may be grown as an undoped, p-type or n-type layer.

In figure 1C a further layer 15 of a material which is not germanium based forms part of the photovoltaic junction 18 with the germanium material layer 14.

Aspects and embodiments of the invention described below are generally illustrated using the scheme of figure 1A, but can equally well be implemented using schemes such as or similar to those of figures 1B and 1C.

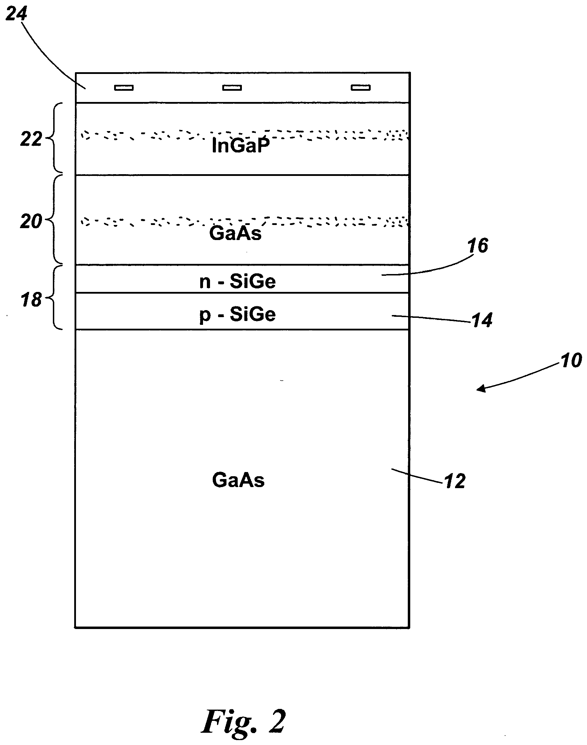

Referring to figure 2 there is shown schematically the photovoltaic cell structure 10 of figure 1A (or other similar structures), with the addition of further overlying photovoltaic junctions. These overlying junctions are typically formed epitaxially, for example using materials substantially lattice matched to GaAs. In particular, an intermediate photovoltaic junction formed of GaAs materials is shown as junction 20, and an upper photovoltaic junction formed of InGaP materials is shown as junction 22. Capping layers 24 may overlie the upper junction. Suitable tunnel junctions may be provided between the photovoltaic junctions. The intermediate junction may typically have a bandgap of around 1.4 eV. The upper junction may typically have a bandgap of around 1.85 eV. Other combinations of photovoltaic junctions of various materials and structures known in the art may be used.

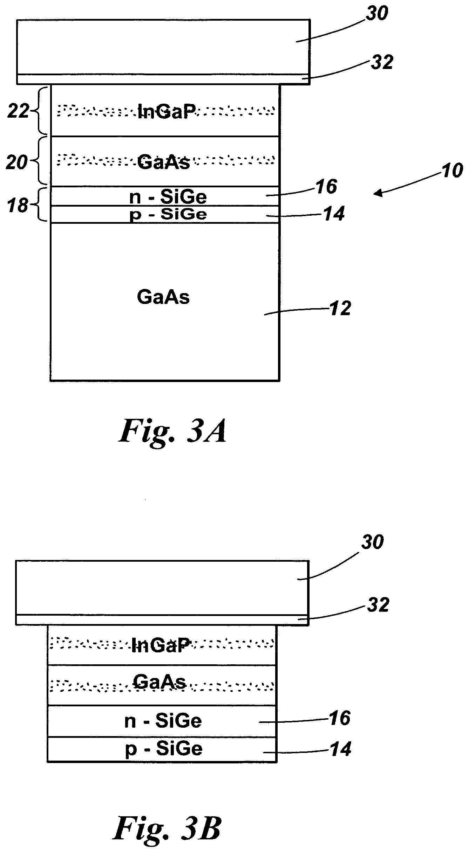

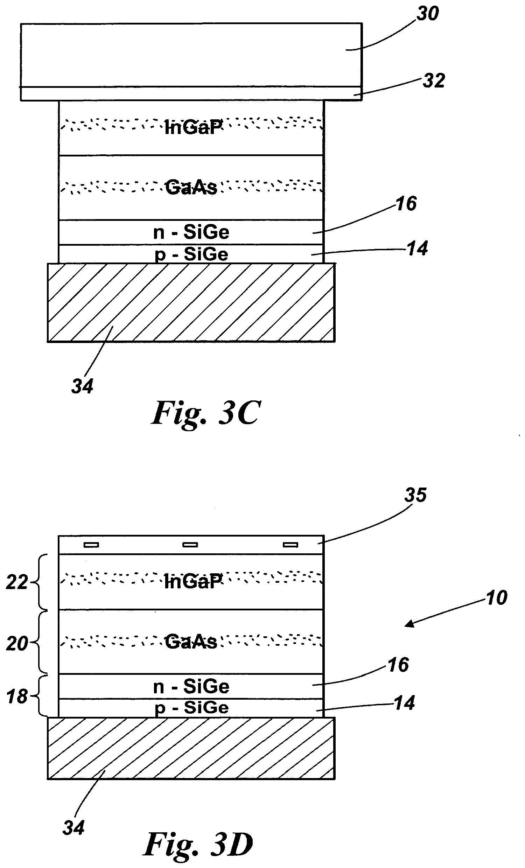

Processes involving removal of the GaAs substrate from photovoltaic cell structures such as those illustrated in figures 1A, 1B, 1C and 2 will now be described. The structure of figure 2 will be used as an example not being part of the invention, but it should be understood that other photovoltaic cell structures based on the structure of figures 1A - 1C may also be used. As shown in figure 3A, a handling wafer 30 is bonded to an upper surface of the structure 10. This may be before or after some or all capping layers 24 such as window and electrode layers have been added. The bonding may be achieved using a temporary bonding layer 32. The GaAs substrate is then removed, for example by grinding followed by selective wet etching, to leave a structure as illustrated in figure 3B. When the GaAs substrate has been removed, an alternative base 34 may be provided in substitution. Figure 3C shows a heatsink, for example provided by a metallic layer, being provided in replacement of the GaAs substrate, although other alternative bases could be provided. Finally, as shown in figure 3D, the handle wafer 30 and temporary bonding layer 32 are removed. If still required, further layers 35 may then be added to the top of the device structure.

In this process, the change of material composition between the GaAs substrate and the one or more first SiGe layers 14,16 provides a hetero-interface which acts as a good etch-stop, enabling the GaAs substrate to be removed conveniently and accurately to leave a smooth surface of the lower SiGe layer 14. Some of the GaAs substrate may be removed by mechanical means if this provides more rapid or otherwise convenient or cost-effective manufacture process. For example, if the GaAs substrate is 500 µm thick, about 400 µm may be removed by grinding from which the GaAs material can be more easily recovered and re-used, and the final 100 µm may be removed by selective wet etching.

The photovoltaic cell structure resulting from use of this method, as shown in figure 3D, can be of lighter weight because the substrate thickness has been removed, which may be important particularly in space-based applications. An alternative base which has favourable flexibility, thermal behaviour, or other desirable mechanical or electrical properties may be advantageously provided. Replacement of the substrate with a heatsink can result in more efficient thermal conduction away from the device because the substrate no longer acts to reduce the flow of heat. The heatsink or another metallic base layer can act directly as a conductive electrode to the bottom of the device.

This process cannot be carried out in a device constructed with the prior art techniques outlined in US 6,380,601, and US 2002/0040727, because these techniques do not provide a suitable hetero-interface to act as an etch-stop between the substrate and the lower junction 18.

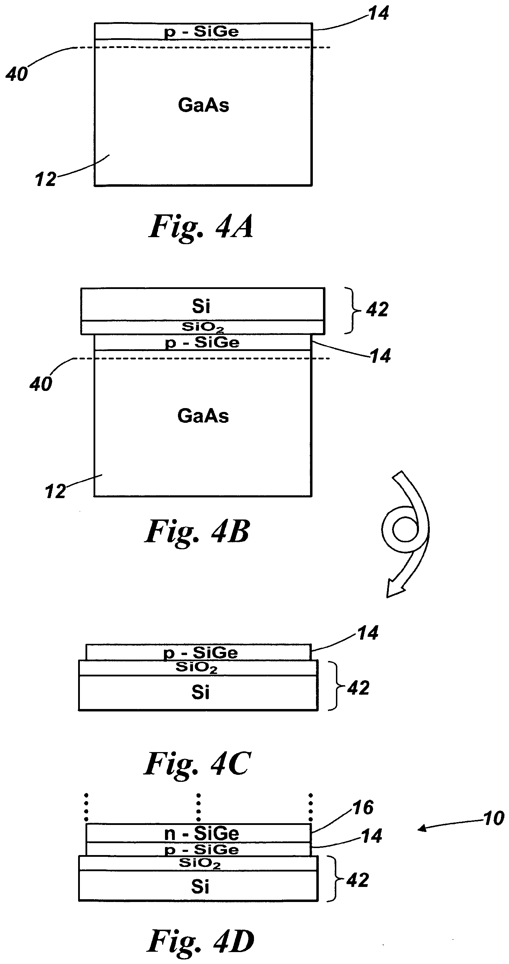

Another technique for providing an alternative base for the structures of figures 1A - 1C is illustrated in figures 4A - 4E. Starting with a GaAs substrate, a lower layer 14 of SiGe is grown epitaxially as previously described, and as shown in figure 4A. A layer transfer technique is then used to remove all but a thin layer of the GaAs substrate. The layer transfer may be achieved using a proprietary exfoliation technique such as Smart Cut (RTM) or similar, in which a cleave plane 40 is formed in the GaAs substrate just beneath the first layer 14 of SiGe. The cleave plane 40 may be formed using ion beam implant techniques to deposit hydrogen or helium atoms at a precise depth determined by the beam particle energy, for example at depths of up to about 1.5 µm, making the technique practical in the present context if the thickness of the lower layer of SiGe is of approximately this thickness. The technique may also be used following growth of both the first layers of SiGe (in inverse order), if the combined thickness of the two layers is not too great for the layer transfer technique to be used effectively or conveniently.

An alternative base is then bonded to the SiGe layer 14. As shown in figure 4B the alternative base may be an oxidised silicon wafer 42 such that the SiGe layer is bonded to a layer of SiO₂, although other bases may be used such as the metallic heat sink layer discussed above. Some other bases which can be used are metallic, glass and semiconductor bases, which may themselves already comprise two or more layers selected from metal, semiconductor and insulator materials, and may include active elements such as one or more photovoltaic junctions. The bulk of the GaAs substrate is then separated from the structure, and the fine remaining layer of GaAs is removed, for example by selective wet etching, to leave the first layer 14 of SiGe on an alternative base such as the oxidised silicon wafer discussed, and as shown in figure 4C.

Another first layer 16 of SiGe (if not already present) and subsequent photovoltaic device structures may then be formed as shown in figure 4D, for example as discussed elsewhere in this document and as already illustrated in figures 1A and 2.

One variation of the described technique is to form the cleave plane just above the interface with the substrate, within the lower SiGe layer. Following layer transfer the transferred SiGe is already exposed for any necessary further preparation. The residual SiGe remaining on the GaAs substrate can be removed, at least partially using a net etch selective for SiGe and ineffective on GaAs, to leave a reuseable GaAs substrate wafer.

This and other layer transfer techniques which can be used to set out in detail in the commonly filed and copending patent application entitled "Formation of thin layers of GaAs and germanium materials", which is hereby incorporated by reference in its entirety for all purposes.

A wide variety of different alternative bases may be contemplated for the structure of figure 4D, including metallic, glass, and semiconductor bases, which may themselves already comprise two or more layers selected from metal, semiconductor, and insulator materials, and may include active elements such as one or more photovoltaic junctions. The initial formation of one or more SiGe layers on a GaAs substrate provides an ideal etchstop for accurate removal of the remaining GaAs following cleaving or exfoliation.

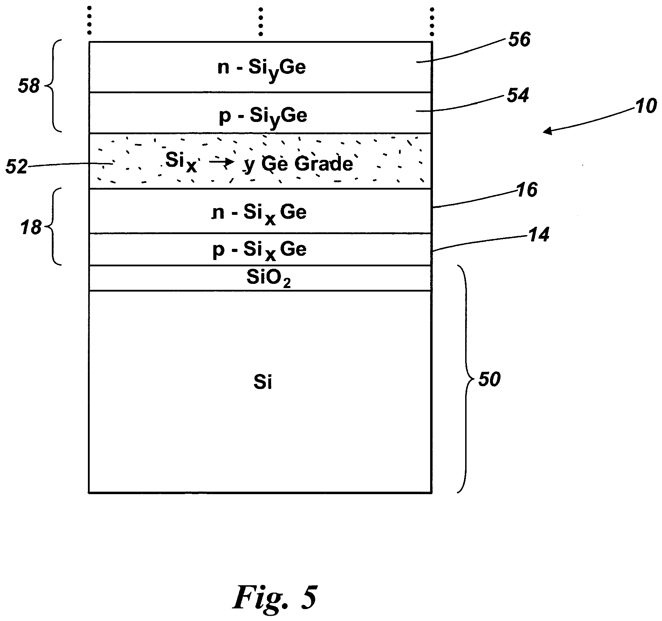

Starting with the structure of figure 1A or figure 4D, an alternative scheme for constructing further layers is shown in figure 5, according to the invention. Figure 5 shows a base layer 50 of silicon oxide on a silicon substrate, but other base layers including the original GaAs substrate may be used. Following formation of the two first SiGe layers 14,16 discussed in connection with figure 1A, a grade layer 52 has been grown on the upper first SiGe layer 16. The grade layer 52 is also formed of SiGe and provides a transition in lattice spacing between the SiGe of the upper first SiGe layer 16, in which the Si fraction is denoted x, and a further, overlying lower second SiGe layer 54 in which the Si fraction is denoted y, where y>x. An upper second SiGe layer 56 with a similar or identical Si fraction y is grown above the lower second layer, to thereby form a second SiGe photovoltaic junction 58. Because the SiGe material of the second photovoltaic junction 58 has a higher silicon content than the first junction 18, the bandgap of this second SiGe junction is higher, and moreover is tunable by adjusting the value of y during manufacture from close to the bandgap of Ge at about 0.67 eV for a material with little or no Si content, to close to the bandgap of Si at about 1.12 eV, for a material with little or no Ge content. A suitable bandgap range which may be desirable in a multi-junction solar cell is about 0.85 eV to about 1.05 eV. The SiGe grade layer permits the second SiGe layers to be strain relaxed with a low density of threading dislocations, and as illustrated in figures 1B and 1C for the first layer, just one second layer may be used.

The one or more second SiGe layers can be grown using techniques and parameters similar to those discussed above in respect of the first layers. Further layers including further junction layers may be added to the structure, either by using materials lattice matched to the second layers, or by other techniques as outlined below.

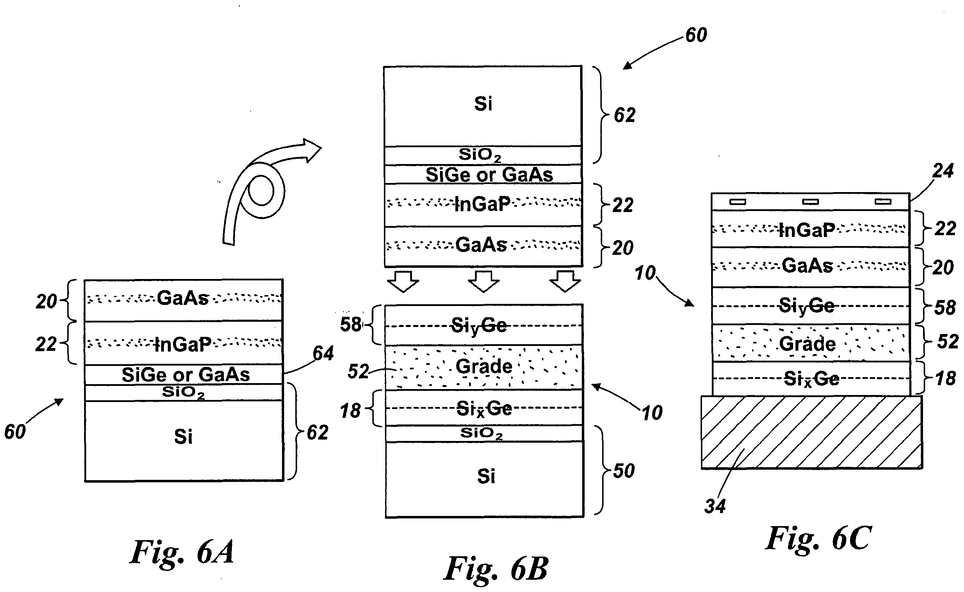

The SiGe grade 52 has the effect that the second SiGe junction 58 is formed of material which is not lattice matched to GaAs. To provide one or more further photovoltaic junctions which are lattice matched to GaAs, on top of the structure of figure 5, an ancillary structure 60 as shown in figure 6A is formed. This structure is based on an ancillary substrate 62. The photovoltaic junctions required for adding above the second SiGe junction 58 are then formed on the ancillary substrate 62 in inverted order. The ancillary structure 60 is then inverted and bonded to the second SiGe junction 58 as shown in figure 6B, to provide the required photovoltaic cell structure sandwiched between the ancillary substrate 62 above and the base layer 50 below. The base layer 50 may then be removed if desired, for example for replacement by a heat sink, or other base structure as listed in previous examples. The ancillary substrate 62 is removed to expose the top of the photovoltaic cell structure, and further layers such as any window and electrode layers not already provided, may be added, thereby providing a quadruple tandem photovoltaic cell structure as illustrated in figure 6C.

The ancillary structure shown in figure 6A includes an ancillary substrate 62 formed of an oxidised silicon wafer, on which a thin lattice matching layer 64, for example formed of SiGe or GaAs is provided, for example by layer transfer / exfoliation as already described above in connection with figures 4A and 4B. Because this lattice matching layer is of well formed GaAs, or SiGe lattice matched to GaAs, further structures incorporating GaAs may be grown with good material quality. In the example of figure 6A an upper photovoltaic junction 22 based on GalnP materials is then formed above the lattice matching layer 64, and an intermediate photovoltaic junction 20 formed of GaAs materials is formed above the upper junction 22. Suitable materials, structures, and other variations for these junctions have already been discussed above with respect to figure 2. Noting that the upper junction may have a bandgap of around 1.85 eV, the intermediate junction may have a bandgap of around 1.4 eV, and the first SiGe junction may have a bandgap of around 0.7 eV, a suitable bandgap for the second SiGe junction may be about 0.95 eV, although using the described construction and techniques, this can be tuned as desired to optimise the efficiency of the photovoltaic cell, for example to different light spectra and intensities. Tunnel junctions and other elements may be provided for ensuring appropriate current flow between various parts of the device.

### Variations

It will be apparent that a range of modifications and variations may be made in respect of the described embodiments without departing from the invention. The methods and structures may be used for a variety of applications including solar cell applications, thermovoltaic applications, as well as photodetector and other electronics applications.

The invention may be put into effect using a variety of fabrication techniques to form required monolithic structures.

Alternative base structures for the various aspects described may include semiconductors, metals, ceramics, glasses, and combinations of such materials. Alternative bases may include active elements such as photovoltaic junctions including thermovoltaic junctions, and elements ancillary to such junctions. Alternative base structures may be used as heatsinks to provide improved thermal transfer (for example compared with the original substrate) and other desired functionality.

## Claims

1. A method of forming a photovoltaic cell comprising:
providing a GaAs substrate (12);
forming a Germanium based first photovoltaic junction (18) over the GaAs substrate (12), the junction comprising one or more first epitaxially grown semiconductor layers (14, 16) of SiGe material substantially lattice matched to the GaAs substrate (12), wherein the one or more first layers (14, 16) are formed of oppositely doped SiₓGe₁₋ₓ in which x<0.04, and more preferably 0.01≤x≤0.03; and
forming one or more further photovoltaic junctions (58) over the first junction (18) such that during operation a common photocurrent flows through the first (18) and further photovoltaic junctions (58),
**characterised in that** said one or more further photovoltaic junctions (58) comprises a second photovoltaic junction comprising one or more second epitaxially grown layers (54, 56) of SiGe materials having a higher silicon content than the first layers (14, 16), the method further comprising forming a silicon-germanium grade (52) over the germanium based first photovoltaic junction (18) before growth of the second photovoltaic junction (58), the silicon-germanium grade (52) being formed to match the lattice constants of the first (18) and second junctions (58) at respective lower and upper boundaries, wherein the second photovoltaic junction (58) has a bandgap of between 0.85 eV and 1.05.

2. The method of any of claim 1 further comprising removing some or all of the GaAs substrate (12).

3. The method of claim 2 wherein the step of removing comprises removing at least some of the GaAs substrate (12) mechanically or by etching.

4. The method of any of claims 2 to 3 further comprising replacing the GaAs substrate (12), in part or whole, with an alternative base (34).

5. The method of claim 4 wherein the alternative base (34) comprises a heatsink.

6. The method of claim 4 wherein the alternative base comprises a silicon wafer (50).

7. The method of any of claims 2 to 6 wherein at least some of the removed GaAs substrate (12) is reused as a GaAs substrate wafer in a method of formation of another semiconductor device such as another photovoltaic cell.

## Patentansprüche

1. Verfahren zum Bilden einer fotovoltaischen Zelle, umfassend:
Bereitstellen eines GaAs-Substrats (12);
Bilden eines Germanium-basierten ersten fotovoltaischen Übergangs (18) über das GaAs-Substrat (12), wobei der Übergang eine oder mehrere erste epitaxisch gewachsene Halbleiterschichten (14, 16) eines SiGe-Materials umfasst, welches im Wesentlichen an das GaAs-Substrat (12) Gitter-angepasst ist, wobei die eine oder die mehreren ersten Schichten (14, 16) gegensätzlich SiₓGe₁₋ₓ dotiert sind, wobei x<0,04, und weiter bevorzugt 0,01≤x≤0,03; und
Bilden eines oder mehrerer weiterer fotovoltaischer Übergänge (58) über den ersten Übergang (18) derart, dass während eines Betriebs ein gemeinsamer Fotostrom durch den ersten (18) und die weiteren fotovoltaischen Übergänge (58) fließt,
**dadurch gekennzeichnet, dass** der eine oder die mehreren weiteren fotovoltaischen Übergänge (58) einen zweiten fotovoltaischen Übergang umfassen, welcher eine oder mehrere zweite epitaxisch gewachsene Schichten (54, 56) von SiGe-Materialien umfasst, welche einen höheren Siliziumgehalt aufweisen als die ersten Schichten (14, 16), wobei das Verfahren ferner ein Bilden eines Silizium-Germanium-Grads (52) über den Germanium-basierten ersten fotovoltaischen Übergang (18) vor einem Wachsen des zweiten fotovoltaischen Übergangs (58) umfasst, wobei der Silizium-Germanium-Grad (52) gebildet wird, um zu den Gitterkonstanten der ersten (18) und zweiten Übergänge (58) an entsprechenden unteren und oberen Grenzen zu passen, wobei der zweite fotovoltaische Übergang (58) eine Bandlücke von zwischen 0,85 eV und 1,05 aufweist.

2. Verfahren nach einem aus Anspruch 1, ferner umfassend ein Entfernen von manchem oder des gesamten GaAs-Substrats (12).

3. Verfahren nach Anspruch 2, wobei der Schritt des Entfernens ein Entfernen von wenigstens manchem des GaAs-Substrats (12) auf mechanische Weise oder durch Ätzen umfasst.

4. Verfahren nach einem der Ansprüche 2 bis 3, ferner umfassend ein Ersetzen des GaAs-Substrats (12) teilweise oder im ganzen mit einer alternativen Basis (34).

5. Verfahren nach Anspruch 4, wobei die alternative Basis (34) eine Wärmesenke umfasst.

6. Verfahren nach Anspruch 4, wobei die alternative Basis einen Silizium-Wafer (50) umfasst.

7. Verfahren nach einem der Ansprüche 2 bis 6, wobei wenigstens manches des entfernten GaAs-Substrats (12) als ein GaAs-Substrat-Wafer in einem Verfahren eines Bildens einer anderen Halbleitervorrichtung wiederverwendet wird, wie beispielsweise eine andere fotovoltaische Zelle.

## Revendications

1. Procédé de formation d'une cellule photovoltaïque comprenant les étapes consistant à :
fournir un substrat de GaAs (12) ;
former une première jonction photovoltaïque à base de germanium (18) sur le substrat de GaAs (12), la jonction comprenant une ou plusieurs premières couches de semi-conducteur à croissance épitaxiale (14, 16) en matériau SiGe correspondant sensible en termes de réseau au substrat de GaAs (12), dans lequel les une ou plusieurs premières couches (14, 16) sont formées de SiₓGe₁₋ₓ dopé de manière opposée où x <0,04, et de manière plus préférée 0,01 ≤ x ≤ 0,03 ; et
former une ou plusieurs jonctions photovoltaïques supplémentaires (58) sur la première jonction (18) de telle sorte qu'en cours de fonctionnement, un photocourant commun circule à travers la première (18) et des jonctions photovoltaïques supplémentaires (58),
**caractérisé en ce que** lesdites une ou plusieurs jonctions photovoltaïques supplémentaires (58) comprennent une seconde jonction photovoltaïque comprenant une ou plusieurs secondes couches à croissance épitaxiale (54, 56) en matériaux SiGe ayant une teneur en silicium supérieure aux premières couches (14, 16), le procédé comprenant en outre la formation d'un niveau de silicium-germanium (52) sur la première jonction photovoltaïque à base de germanium (18) avant la croissance de la seconde jonction photovoltaïque (58), le niveau de silicium-germanium (52) étant formé pour correspondre aux constantes de réseau des première (18) et seconde (58) jonctions aux limites inférieure et supérieure respectives, dans lequel la seconde jonction photovoltaïque (58) a une bande interdite comprise entre 0,85 eV et 1,05.

2. Procédé selon la revendication 1, comprenant en outre le retrait de tout ou partie du substrat de GaAs (12).

3. Procédé selon la revendication 2, dans lequel l'étape de retrait comprend le retrait d'au moins une partie du substrat de GaAs (12) mécaniquement ou par gravure.

4. Procédé selon l'une quelconque des revendications 2 à 3, comprenant en outre le remplacement du substrat de GaAs (12), en partie ou en totalité, par une base alternative (34) .

5. Procédé selon la revendication 4, dans lequel la base alternative (34) comprend un dissipateur thermique.

6. Procédé selon la revendication 4, dans lequel la base alternative comprend une plaquette de silicium (50).

7. Procédé selon l'une quelconque des revendications 2 à 6, dans lequel au moins une partie du substrat de GaAs retiré (12) est réutilisée en tant que plaquette de substrat de GaAs dans un procédé de formation d'un autre dispositif à semi-conducteur tel qu'une autre cellule photovoltaïque.
